# EUROPÄISCHE PATENTSCHRIFT

(11) **EP 3 921 610 B1**
(45) Veröffentlichungstag und Bekanntmachung des Hinweises auf die Patenterteilung: **29.03.2023**
(21) Anmeldenummer: 20704456.1
(22) Anmeldetag: 04.02.2020
(51) Int. Cl.: G01G 21/28, G01G 23/48

(54) **GRAVIMETRISCHES MESSSYSTEM**
GRAVIMETRIC MEASURING SYSTEM
SYSTÈME DE MESURE GRAVIMÉTRIQUE

(30) Priorität: 05.02.2019 DE 102019102805
(43) Veröffentlichungstag der Anmeldung: 15.12.2021
(73) Patentinhaber: Sartorius Lab Instruments GmbH & Co. KG, 37079 Göttingen (DE)
(72) Erfinder: FELDOTTE, Heinrich, 37079 Göttingen (DE); LAUBSTEIN, Michael, 37077 Göttingen (DE); HOLST, Heyko, 37085 Göttingen (DE)
(74) Vertreter: Novagraaf International SA
(86) Internationale Anmeldenummer: PCT/EP2020/052679
(87) Internationale Veröffentlichungsnummer: WO 2020/161104

(56) Entgegenhaltungen:
- EP-A1- 1 312 902
- DE-A1-102014 101 558
- JP-A- H0 228 522

## Beschreibung

### Gebiet der Erfindung

Die Erfindung bezieht sich auf ein gravimetrisches Messsystem, umfassend
- eine Waage mit einem von einer Wägeraumwandung umgebenen Wägeraum, einem elektromechanischen Wägesystem und einer elektronischen Steuereinrichtung zur Steuerung des Systembetriebs gemäß in ihrem Speicher hinterlegten Regeln sowie
- eine Mehrzahl von Funktionsmodulen, die bedarfsweise in an der Wägeraumwandung angeordnete Modulaufnahmen einsetzbar sind.

### Stand der Technik

Derartige gravimetrische Messsysteme sind bekannt aus der EP 1 195 584 A1.

Analyse- und Laborwaagen, insbesondere solche, die auf dem Prinzip der elektromagnetischen Kompensation arbeiten, sind allgemein bekannt. Ein elektromechanisches Wägesystem, d. h. ein typischerweise komplexes Hebelwerk mit einer eingangsseitigen Lastaufnahme und einer ausgangsseitigen Tauchspulenanordnung, ist dabei in einem Wägesystemraum angeordnet, der eine möglichst gute Abschirmung gegenüber Umgebungseinflüssen gewähren soll. Ein mit der Lastaufnahme verbundener Träger ragt in einen üblicherweise benachbarten Wägeraum hinein, der ebenfalls, nämlich durch seine Wägeraumwandung, weitgehend von der Umgebung abgeschirmt ist. Die Wägeraumwandung setzt sich üblicherweise aus dem Wägeraumboden, den Wägeraumdeckel, Wägeraumseitenwänden sowie eine Vorder-und Rückwand zusammen. Die Rückwand kann häufig mit einer Wand des Wägesystemraums zusammenfallen. Eine oder beide Seitenwände des Wägeraums sind häufig als bewegbare Windschutz-Elemente ausgebildet. Auch der Deckel und/oder die Vorderseite können, in der Regel verschließbare, Zugangsöffnungen enthalten. Die Kopplung des Trägers zur Lastaufnahme des Wägesystems durchsetzt üblicherweise die Rückwand oder den Boden des Wägeraums.

Weiter enthalten derartige Waagen stets eine Steuereinrichtung, die insbesondere die Wägesensorik ansteuert und dabei speziell die Tauchspulenanordnung des Wägesystems regelt. Allerdings können die Steuereinrichtungen moderner Waagen deutlich komplexer ausgestaltet sein und insbesondere verschiedene Betriebsvarianten des Systembetriebs zur Verfügung stellen. Solche Betriebsvarianten können die Steuerung der Sensorik oder einer Kühlvorrichtung betreffen, sie können sich jedoch alternativ oder zusätzlich auf die Ansteuerung bestimmter Hilfseinrichtungen im oder am Wägeraum beziehen. Rein beispielhaft seien eine Kühlvorrichtung, eine Windschutzsteuerung, Hebevorrichtungen innerhalb des Wägeraums, Beleuchtungseinrichtungen und ähnliches genannt.

Aus der eingangs genannten, gattungsbildenden Druckschrift ist es bekannt, solche Hilfseinrichtungen mit Wägefunktionsbezug in Form von Modulen, d. h. als wägefunktionsbezogene Module, kurz Funktionsmodule, vorzuhalten und im Wägeraum, insbesondere an dessen Rückwand, eine schienenartige Haltevorrichtung vorzusehen, welche unterschiedliche mechanische Schnittstellen aufweist, an welchen im konkreten Einzelfall benötigte Funktionsmodule in der jeweils benötigten Position festgelegt werden können. Mit anderen Worten sind besagte Funktionsmodule bedarfsweise in entsprechende Modulaufnahmen an der Wägeraumwandung einsetzbar. Ein solch modulares System ist insbesondere in Laborumgebungen vorteilhaft, in denen mit ein und derselben Waage unterschiedliche Wägeaufgaben durchgeführt werden müssen. Die Waage kann dann vom Benutzer selbst entsprechend seinem konkreten Bedarf im Einzelfall konfektioniert werden. Selbst in Fällen, in denen die mechanischen Schnittstellen so gestaltet sind, dass ein Modulaustausch durch den Benutzer unmöglich ist, sind solch modulare Systeme auch herstellerseitig vorteilhaft. Aufbauend auf demselben Waagengrundkörper können durch Wahl der in die Modulaufnahmen eingesetzten Funktionsmodule Waagen für unterschiedliche Wägeaufgaben vorkonfektioniert werden. Die Anzahl herzustellender Spezialteile verringert sich drastisch, was zu einer deutlichen Kosteneinsparung führt.

Problematisch bei dem geschilderten Konzept ist der Umstand, dass unterschiedliche Module unterschiedliche Wärmekapazitäten oder - im Fall aktiver Module, wie bspw. einer Beleuchtung, eines motorischen Moduls, eines Ionisators o. Ä. - eine unterschiedliche Wärmeleistung eingebracht wird. Wägevorgänge sind jedoch bekanntermaßen äußerst temperaturkritisch. Typischerweise wird angestrebt, die Temperatur des gesamten Wägeraums der Umgebungstemperatur exakt anzupassen. Es sind allerdings auch Konzepte bekannt, in denen im Wägeraum ein bestimmter Temperaturgradient aufgebaut werden soll. Beispielhaft sei hierzu die DE 10 2009 055 622 B4 angegeben. In jedem Fall bringt eine Veränderung der Wärmekapazitäten bzw. -leistungen im Wägeraum Probleme im Hinblick auf die Wägeraumtemperierung mit sich. Verallgemeinert liegt das Problem der bekannten Waagensysteme darin, die konkret gewählte Betriebsvariante mit der konkret gewählten Modulkonstellation in Einklang zu bringen.

Die nachveröffentlichte EP 3 557 199 A1 offenbart eine Waage mit einer aus mehreren Wandelementen zusammensetzbaren Wägeraum-Rückwand, deren Höhe auf diese Weise an unterschiedliche Windschutz-Höhen anpassbar ist, mithin Wägeräume unterschiedlicher Höhen aufbaubar sind.

Die EP 1 312 902 A1 offenbart eine Waage, an deren Wägeraum-Rückwand eine elektronische Zusatzeinheit, in welcher Versorgungseinheiten, bspw. eine Batterie, oder auch eine Steuerungselektronik angeordnet sein können, mithin ein Funktionsmodul im hiesigen Sinne, anbringbar ist. Die Druckschrift enthält keinerlei Hinweis auf die damit verbundene Problematik eines Wärmeeintrags in den Wägeraum.

Die EP 1 396 711 B1 offenbart eine Waage mit einem ohne jegliche Funktionsmodule ausgestatteten Wägeraum, die eine über ein thermoelektrisches Element vermittelte Wärmeabfuhr der Wägeelektronik und aus dem Wägeraum aufweist, wobei die spezielle thermische Ankopplung an die Wägeraum-Rückwand für die Ausbildung eines Temperaturgradienten innerhalb des Wägeraums sorgt.

Die DE 10 2014 101 561 A1 offenbart eine gravimetrische Dosiervorrichtung mit einem im Wägeraum angeordneten Klimamessmodul. Auf Basis der damit ermittelten Klimadaten können im Rahmen des Dosiervorgangs zu mischende Komponenten außerhalb der Vorrichtung vortemperiert werden.

Die DE 10 2009 055 624 A1 offenbart eine Waage mit einer in einem Gehäuseunterbau angeordneten Wägeelektronik, die mittels eines thermischen Abschirmblechs gegen insbesondere den Wägeraum abgeschirmt ist, wobei das Abschirmblech mit der kühlenden Seite eines thermoelektrischen Moduls verbunden ist.

Ein ähnlicher Ansatz wird in der JP 2 586 115 B2 verfolgt, wobei sich die thermisch abgeschirmte Wägeelektronik hier in einem Gehäuse hinter dem Wägeraum befindet.

### Aufgabenstellung

Es ist die Aufgabe der vorliegenden Erfindung, ein gattungsgemäßes Waagensystem derart weiterzubilden, dass die für einen korrekten Systembetrieb erforderliche Übereinstimmung von gewählter Betriebsvariante und gewählter Modulkonstellation leichter und sicherer auffindbar ist.

### Darlegung der Erfindung

Diese Aufgabe wird in Verbindung mit den Merkmalen des Oberbegriffs von Anspruch 1 dadurch gelöst, dass jede Modulaufnahme eine geräteseitige Identifikationsschnittstellen-Komponente und jedes Funktionsmodul eine korrespondierende, modulseitige Identifikationsschnittstellen-Komponente aufweist und dass die Steuereinrichtung eingerichtet ist, jedes in eine Modulaufnahme eingesetzte Funktionsmodul durch Wechselwirkung zwischen der jeweiligen geräte- und modulseitigen Identifikationsschnittstellen-Komponenten zu identifizieren und auf Grundlage von in ihrem Speicher hinterlegten Regeln eine von mehreren Betriebsvarianten auszuwählen.

Bevorzugte Ausführungsformen sind Gegenstand der abhängigen Patentansprüche.

Kern der Erfindung ist somit die automatische Erkennung der konkret gewählten Modulkonstellation und die darauf abgestimmte, automatische Auswahl, der passenden Betriebsvariante. Die hierfür erforderliche Identifikationsschnittstelle, d. h. die Kombination aus geräte- und modulseitiger Identifikationsschnittstellen-Komponente, kann dabei auf unterschiedliche Weise ausgestaltet sein. Denkbar ist eine mechanische Wechselwirkung zwischen einem Höhenprofil als Modulkennzeichnung und einer Tastvorrichtung, bspw. in Form von Mikroschaltern, als geräteseitige Identifikationsschnittstellen-Komponente. Die Tastvorrichtung ist dann datenübertragend, insbesondere elektrisch, mit der Steuereinheit verbunden. Auch eine optische oder magnetische Sensorik kann als Identifikationsschnittstelle genutzt werden, ebenso ist es möglich funkgestützte Identifikationsschnittstellen, bspw. auf Transponder- bzw. RFID-Basis, zu realisieren. Durch solche Schnittstellen, deren geräteseitige Komponenten an jeder Modulaufnahme und deren modulseitige Komponenten an jedem Modul installiert sind, lassen sich sowohl die Anzahl als auch die Art der jeweils installierten Module detektieren und an die Steuereinrichtung übermitteln. In deren Speicher sind Regeln hinterlegt, auf deren Basis dann eine sinnvolle, angepasste Betriebsvariante ausgewählt wird, die sodann dem weiteren Systembetrieb zugrunde gelegt wird.

Die in der Steuereinrichtung vorgenommene Anpassung der Betriebsvariante an die jeweils detektierte Modulkonstellation kann sämtliche variierbaren Aspekte des Systembetriebs betreffen. Insbesondere kann die Temperaturregulierung im Wägeraum betroffen sein. So ist bei einer bevorzugten Ausführungsform der Erfindung vorgesehen, dass die Waage eine von der Steuereinrichtung steuerbare Kühlvorrichtung zur Kühlung des Wägeraums aufweist und die Steuereinrichtung eingerichtet ist, die Kühlvorrichtung mit einer von der Art und Anzahl der identifizierten Module abhängigen, statischen Kühlleistung anzusteuern. Bei einer solchen Ausführungsform kann weitgehend auf eine komplexe Temperaturregelung verzichtet werden. Es hat sich nämlich herausgestellt, dass, sofern die Waage an einem geeigneten Aufstellungsort ohne übermäßige Schwankungen von Umgebungsparametern aufgestellt ist, wie dies für Laborwaagen der Normalfall ist, ein Betrieb der Kühlvorrichtung mit einer statischen Kühlleistung ausreicht. Die erforderliche statische Kühlleistung ist jedoch von der konkreten Modulkonstellation abhängig. Dies gilt in ganz besonderem Maße in Fällen, in denen aktive Module, die eine positive Wärmeleistung in den Wägeraum einbringen, installiert sind. Beispiele hierfür sind, Beleuchtungen, Anzeigen, Ionisatoren, Codescanner, motorische Elemente, wie Hebeeinrichtungen, etc.. Herstellerseitig sind die modulspezifischen Wärmeleistungen genau bekannt. Es kann sich hierbei um modulartspezifische oder sogar um modulindividuelle Werte handeln. Herstellerseitig lässt sich also im Speicher der Steuereinrichtung für jedes denkbarerweise installierbare Modul die zugeordnete Wärmeleistung hinterlegen bzw. ein zu ihrer Kompensation erforderlicher Kühlleistungsbetrag, um welchen die statische Kühlleistung erhöht wird, sobald die Installation des entsprechenden Moduls auf Basis der Identifikationsschnittstelle detektiert worden ist. Die Anpassung der Temperaturregulierung erfolgt daher durch statische Ansteuerung der Kühlvorrichtung und bedarf keiner aufwändigen Regelung. Man beachte, dass in der Regel zusätzlich eine (ebenfalls statische) modulunabhängige Grundkühlleistung zu erbringen sein wird, welche von der Kühlvorrichtung auch in solchen Fällen geliefert wird, in denen kein oder zumindest kein aktives Funktionsmodul installiert ist.

Der Begriff des Speichers der Steuereinrichtung ist in diesem Zusammenhang ebenso wie der Begriff des Hinterlegens von Regeln und/oder Werten im Speicher weit zu verstehen. Er umfasst selbstverständlich lokale Speicher - sei es geräte- oder modulseitig. Er ist jedoch auch auf externe Speicher, beispielsweise eine Cloud oder einen externen Server, zu beziehen. So soll es im Rahmen der vorliegenden Erfindung auch möglich sein, dass die Steuereinrichtung die ermittelte Modulkonstellation an eine externe Einheit, bspw. über Internet, übermittelt und von dort die konkreten Informationen zur Wahl der passenden Betriebsvariante erhält. Diese Ausführungsform der Erfindung hat den Vorteil, dass Informationen über neuentwickelte Module lediglich zentral hinterlegt werden müssen und nicht, bspw. über ein Firmware-Update, in jeder lokalen Steuereinrichtung aktualisiert werden müssen.

Wie erläutert, liegt ein Vorteil der oben geschilderten, modulabhängig stufenweise einstellbaren statischen Kühlleistung im Entfall der Notwendigkeit einer komplexen Temperaturregelung. Dies schließt jedoch eine einfache Regelung nicht aus. So kann bei einer Weiterbildung der besagten Ausführungsform vorgesehen sein, dass die Steuereinrichtung weiter eingerichtet ist, die Kühlvorrichtung zusätzlich mit einer von temporären Umgebungseinflüssen abhängigen, dynamischen Korrekturkühlleistung zu regeln. So kann es auch an gut temperierten Aufstellungsorten, bspw. durch wechselnde Sonneneinstrahlung, zu geringfügigen Schwankungen der Umgebungstemperatur der Waage kommen. Derartige Schwankungen werden selbstverständlich von einer statischen Grundkühlleistungssteuerung nicht abgefangen. Solch geringfügige Schwankungen können jedoch leicht mit einer einfachen Korrekturkühlleistungs-Regelung kompensiert werden, die quasi auf der statischen Kühlleistungs-Steuerung aufsetzt. Diese Korrekturkühlleistungs-Regelung kann modulunabhängig gestaltet sein, da die modulabhängigen Wärmekapazitäts- bzw. -leistungsbeiträge ja bereits durch die stufenweise statische Kühlleistungs-Steuerung berücksichtigt werden.

Als Alternative zur oben ausführlich erläuterten, stufenweisen statischen Kühlleistungs-Steuerung kann bei einer anderen Ausführungsform der Erfindung vorgesehen sein, dass die Waage eine von der Steuereinrichtung steuerbare Kühlvorrichtung zur Kühlung des Wägeraums aufweist und die Steuereinrichtung eingerichtet ist, die Kühlvorrichtung zur Konstanthaltung einer vorgegebenen Wägeraumtemperatur mittels einer Regelung zu regeln, deren Regelparameter von der Art und Anzahl der identifizierten Module abhängig ist. Bspw. kann im Rahmen dieser Anpassung der Regelparameter berücksichtigt werden, dass die im Hinblick auf eine möglichst schnelle Erreichung einer Zieltemperatur optimale Schrittgröße bei Veränderungen der Kühlleistung abhängig sein kann von der Wärmekapazität bzw. -leistung des zu kühlenden Gegenstandes, d. h. hier insbesondere von der Anzahl und Art der im Wägeraum installierten Module. Weitere Merkmale und Vorteile der Erfindung ergeben sich aus der nachfolgenden speziellen Beschreibung und den Zeichnungen.

### Kurzbeschreibung der Zeichnungen

Es zeigen:
- Figur 1:: eine schematische Darstellung eines erfindungsgemäßen gravimetrischen Messsystems im Montageendzustand mit unvollständig dargestellter Wägeraumwandung,
- Figur 2:: die Wägeraumrückwand der Waage des gravimetrischen Messsystems von Figur 1 in einem Montagezwischenzustand ohne eingesetzte Funktionsmodule oder Blenden,
- Figur 3:: eine unvollständige Schnittdarstellung der Wägeraumrückwand der Waage des gravimetrischen Messsystems von Figur 1 und daran angrenzender Bereiche sowie
- Figur 4:: eine schematische Darstellung einer bevorzugten Kühlungssteuerung der Waage des gravimetrischen Messsystems von Figur 1.

### Beschreibung bevorzugter Ausführungsformen

Gleiche Bezugszeichen in den Figuren deuten auf gleiche oder analoge Elemente hin.

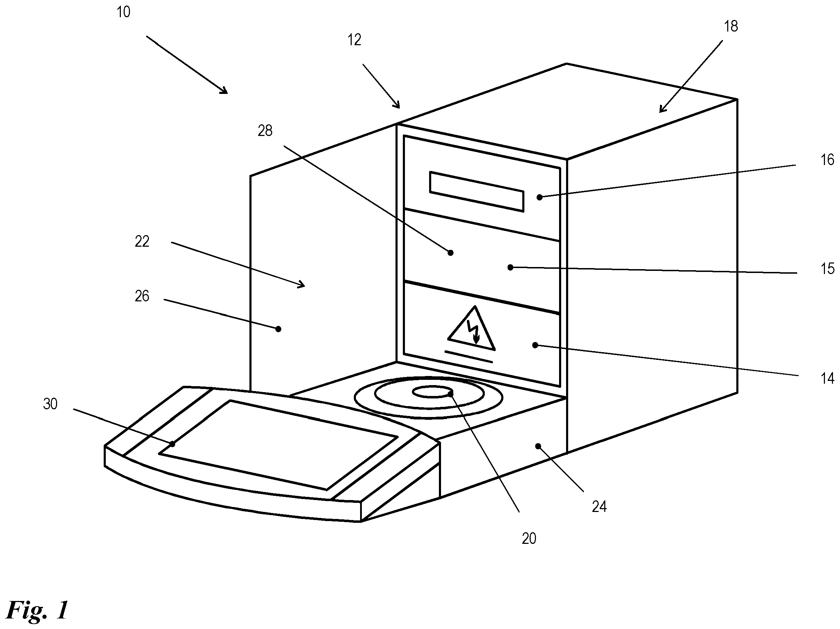

Figur 1 zeigt eine schematische Darstellung eines erfindungsgemäßen gravimetrischen Messsystems 10, welches im Wesentlichen aus einer Waage 12 und zwei darin eingesetzten Funktionsmodulen 14, 16 sowie einer Blende 15 besteht. Bei der gezeigten Ausführungsform ist das mit dem Bezugszeichen 14 versehene Funktionsmodul eine zur Erkennung von Barcodes geeignete Laserscannereinheit und das mit dem Bezugszeichen 16 versehene Funktionsmodul eine Beleuchtungseinheit. Die konkreten Funktionen der Funktionsmodule 14, 16 spielen im Kontext der vorliegenden Erfindung jedoch keine Rolle.

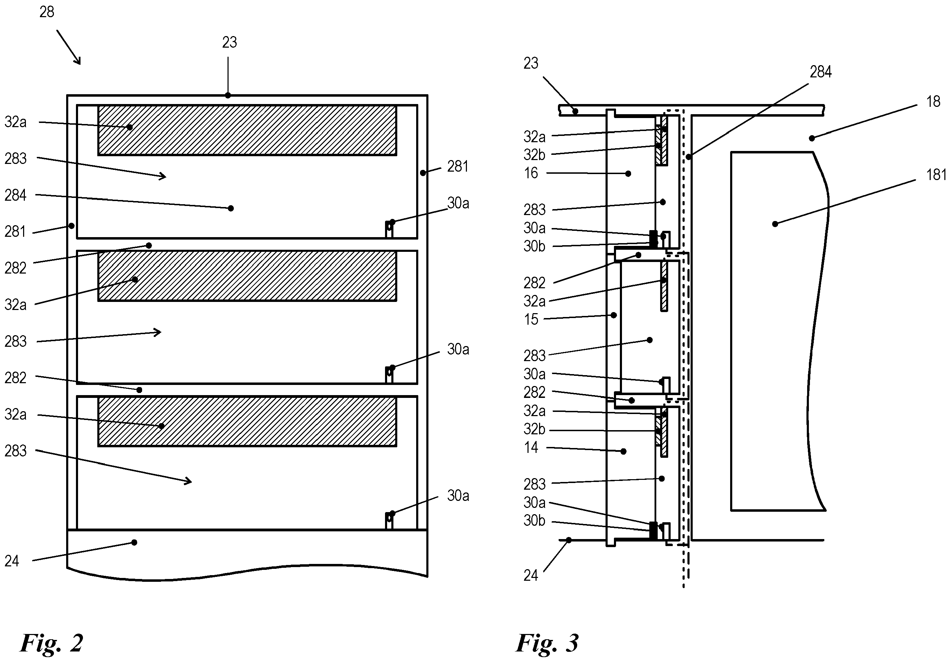

Die Waage 12 umfasst bei der gezeigten Ausführungsform im Wesentlichen drei Bereiche, nämlich einen Wägesystemraum 18, in dem ein in Figur 3 angedeutetes Wägesystem 181 angeordnet ist. Der konkrete Aufbau des Wägesystems 181 spielt im Kontext der vorliegenden Erfindung keine Rolle. Das Wägesystem 181 umfasst in jedem Fall eine nicht gesondert dargestellte Lastaufnahme, die mit einem Wägegutträger 20 verbunden ist, welcher seinerseits in einem bei der dargestellten Ausführungsform an den Wägesystemraum 18 angrenzenden Wägeraum 22 angeordnet ist. Der Wägeraum 22 ist von einer Wägeraumwandung umgeben, die in Figur 1 nur unvollständig dargestellt ist. Insbesondere sind der von dem Wägegutträger 20 durchsetzte Wägeraumboden 24, eine Wägeraumseitenwand 26 sowie eine Wägeraumrückwand 28, auf die weiter unten noch näher einzugehen sein wird, dargestellt. Die Wägeraumrückwand 28 ist bei der Darstellung von Figur 1 im Wesentlichen durch die Frontseiten der Funktionsmodule 14, 16 sowie die zwischen diesen Funktionsmodulen 14, 16 angeordnete Blende 15 verdeckt. Typischerweise umfasst die Wägeraumwandung zusätzlich eine weitere Wägeraumseitenwand, eine Wägeraumvorderwand und einen (nur in den Figuren 2 und 3 angedeuteten) Wägeraumdeckel 23, die aus Gründen der besseren Übersichtlichkeit in Figur 1 jedoch nicht dargestellt sind.

Weiter umfasst die Waage 12 eine Elektronikeinheit 30, die bei der gezeigten Ausführungsform im Wesentlichen eine großformatige Anzeige umfasst. Die Elektronikeinheit 30 kann zusätzlich eine Steuereinrichtung enthalten, auf die weiter unten noch näher einzugehen sein wird. Diese Steuereinrichtung kann jedoch auch an anderer Stelle der Waage 12 angeordnet sein. Als günstig wird angesehen, wenn diese Steuereinheit thermisch isoliert vom Wägesystemraum 18 sowie vom Wägeraum 22 angeordnet ist.

Figur 2 zeigt eine Frontalansicht der Wägeraumrückwand 28, allerdings ohne die eingesetzten Funktionsmodule 14, 16 und ohne die Blende 15. Figur 3 zeigt eine Schnittansicht der Wägeraumrückwand 28 und angrenzender Bereiche der Waage 12, wobei die Darstellung von Figur 3 allerdings auch die eingesetzten Funktionsmodule 14, 16, sowie die eingesetzte Blende 15 zeigt. Trotz dieses Unterschiedes erleichtert eine Zusammenschau der Figuren 2 und 3 das Verständnis der nachfolgenden Beschreibung.

Die Wägeraumrückwand 28 ist aus senkrechten Pfosten 281 und quer dazu angeordneten Streben 282 aufgebaut. Zwischen diesen erstrecken sich Ausnehmungen 283, die hier auch als Modulaufnahmen 283 bezeichnet werden. Wägesystemraumseitig weist die Wägeraumrückwand 28 eine den Wägesystemraum 18 versiegelnde Abschlusswand 284 auf, die einen Durchgriff durch die Modulaufnahmen 283 in den Wägesystemraum 18 verhindert. Bei der dargestellten Ausführungsform ist die Abschlusswand 284 zugleich die Vorderwand des Wägesystemraums 18.

Die Modulaufnahmen 283 dienen der räumlich angepassten Aufnahme der Funktionsmodule 14, 16. In die in den Figuren 2 und 3 mittlere Modulaufnahme 283 ist bei der Ausführungsform der Figuren 1 und 3 kein Funktionsmodul eingesetzt. Diese Ausnehmung 283 zwischen den Pfosten 281 und Streben 282 ist durch die Blende 15 zum Wägeraum hin verschlossen. Die Modulaufnahmen 283 sind hinsichtlich ihrer nachfolgend näher zu beschreibenden Ausstattung identisch ausgebildet, sodass die Funktionsmodule 14, 16 ebenso wie andere, kompatibel ausgebildete Funktionsmodule in jede der Modulaufnahmen 283 einsetzbar sind. Hinsichtlich ihrer Größe sind die Modulaufnahmen 283 bevorzugt identisch, besonders bevorzugt ohne Trennelement ineinander übergehend ausgebildet, sodass Funktionsmodule 14, 16, deren Größe einem ganzzahligen Vielfachen einer Einheitsgröße entspricht, exakt in eine oder in mehrere einander benachbarte Modulaufnahmen 283 passend eingesetzt werden können. Denkbar ist auch, dass die Größen der Modulaufnahmen 283 selbst unterschiedliche ganzzahlige Vielfache einer Einheitsgröße sind. Gleiches wie für die Funktionsmodule 14, 16 gilt selbstverständlich auch für die Blenden 15.

Jede Modulaufnahme 283 verfügt über eine geräteseitige Identifikations-schnittstellenkomponente 30a, die mit einer korrespondierenden, modulseitigen Identifikations-Schnittstellenkomponente 30b eines eingesetzten Funktionsmoduls 14, 16 wechselwirken kann, um das eingesetzte Funktionsmodul 14, 16 zu identifizieren und über eine entsprechende Datenleitung (gestrichelte Linien) mit einer Steuereinheit zu verbinden.

Weiter weist jede Modulaufnahme 283 eine geräteseitige Thermo-Schnittstellenkomponente 32a auf, die mit einer korrespondierenden, modulseitigen Thermo-Schnittstellenkomponente 32b eines eingesetzten Funktionsmoduls 14, 16 in thermischem Kontakt steht. Die geräteseitigen Thermo-Schnittstellenkomponenten 32b sind untereinander sowie mit einer nicht dargestellten Kühlvorrichtung thermisch verbunden (punktierte Linien).

Weitere Schnittstellen, wie beispielsweise elektrische und datentechnische Schnittstellen zur Ansteuerung der Funktionsmodule 14, 16 sind zwar vorzugsweise vorgesehen, in den Figuren der Übersichtlichkeit halber nicht dargestellt.

Eine Besonderheit der modulseitigen Thermo-Schnittstellenkomponenten 32b der gezeigten Ausführungsform liegt darin, dass sie im Vergleich zu den geräteseitigen Thermo-Schnittstellenkomponenten 32a sowie untereinander unterschiedliche Kontaktflächengrößen aufweisen. Sämtliche modulseitigen Thermo-Schnittstellenkomponenten 32b sind kleiner als oder höchstens genauso groß wie die untereinander gleich großen, geräteseitigen Thermo-Schnittstellenkomponenten 32a. Die spezielle Größe der modulseitigen Kontaktflächen hängt von der Wärmeleistung der jeweiligen Funktionsmodule 14, 16 ab. Insbesondere kann eine Proportionalität zwischen der Wärmeleistung und der thermischen Kontaktflächengröße der Module bestehen.

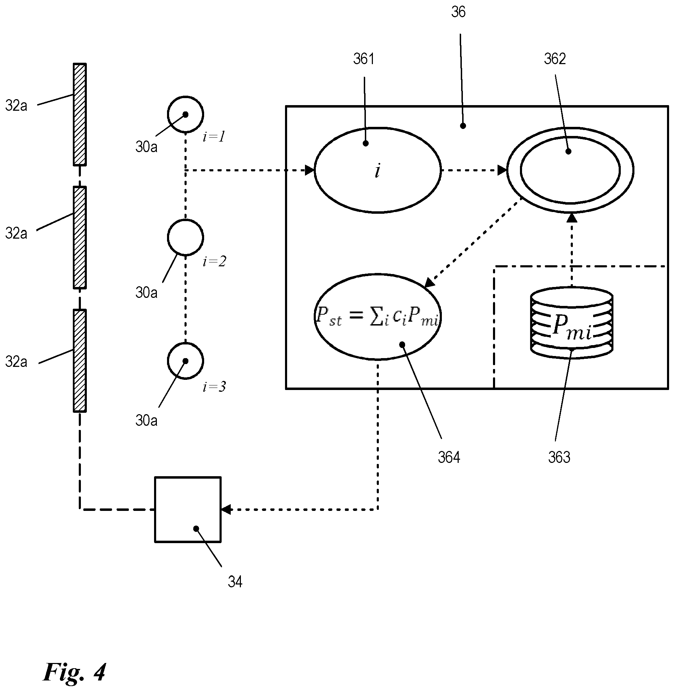

Figur 4 zeigt eine bevorzugte Ausführungsform einer Steuerung der Waage 12. Dargestellt sind die thermisch untereinander sowie mit einer Kühlvorrichtung 34 verbundenen, geräteseitigen Thermo-Schnittstellenkomponenten 32a sowie die geräteseitigen Identifikations-Schnittstellenkomponenten 30a, die hier jeweils mit dem Index i identifiziert sind. Die durch Wechselwirkung der geräteseitigen und modulseitigen Identifikations-Schnittstellenkomponenten 30a, b gewonnenen Identifikationsdaten, werden an eine Steuereinrichtung 36, dort insbesondere an die Identifikationseinheit 361 gesendet. Bei der in den Figuren 1 und 3 dargestellten Ausführungsform würde die Identifikations-Schnittstelle i=1 die Information über das eingesetzte Beleuchtungsmodul 16 liefern. Die Identifikations-Schnittstelle i=2 würde die Information über das Fehlen eines eingesetzten Funktionsmoduls liefern und die Identifikations-Schnittstelle i=3 würde die Information über das eingesetzte Laserscanner-Modul 14 liefern. Die Identifikation kann modultypspezifisch oder sogar modulindividuell erfolgen. Die Identifikationsdaten werden von der Identifikationseinheit 361 an eine Zentraleinheit 362 gesendet. Diese erhält aus einer Speichereinheit 363 Informationen über die konkreten Wärmeleistungen der identifizierten Funktionsmodule 14, 16. Wie durch die strichpunktierte Linie angedeutet, kann die Speichereinheit 363 in die Steuereinrichtung 36 integriert oder entfernt davon, beispielsweise in einem über Internet angebundenen Server, vorgehalten sein. Allerdings kann diese Information auch in einer Speichereinheit des Funktionsmoduls selbst vorgehalten werden. Insbesondere kann vorgesehen sein, dass das Funktionsmodul nach seiner Fertigung werksseitig im Rahmen der Qualitätskontrolle eine individuelle Messung seiner Wärmeleistung durchläuft, deren Ergebnis dann in der Speichereinheit hinterlegt wird. Auch eine typenspezifische Hinterlegung ohne individuelle Messung ist möglich. In jedem Fall verbindet die Informationshinterlegung im Modul selbst die Vorteile der Entlastung der Waagen-Steuereinheit, der Unabhängigkeit von externen Datenquellen und der Möglichkeit der Individualisierung.

Aus den Identifikationsdaten einerseits und den Wärmeleistungsdaten andererseits berechnet die Zentraleinheit 362 die Vorgabewerte zur Ansteuerung der Kühlvorrichtung 34, die an eine mit der Kühlvorrichtung verbundene Kühlungssteuerungseinheit 364 weitergegeben werden. Bei der dargestellten Ausführungsform entspricht die vorgegebene Kühlleistung Pₛₜ einer statischen Kühlleistung, die sich aus der Summe der Einzelwärmeleistungen Pₘᵢ der identifizierten Funktionsmodule 14, 16, jeweils multipliziert mit einem Wichtungsfaktor cᵢ, zusammensetzt: *Pₛₜ* = ∑*ᵢcᵢPₘᵢ.* Die Gesamtkühlleistung P ergibt sich in diesem Fall als Summe einer in Figur 4 nicht erwähnten, modulunabhängigen Grundkühlleistung P₀ und der modulabhängigen statischen Kühlleistung Pₛₜ: *P* = *P*₀ + *Pₛₜ* + *Pᵥ*

Mit dem Wichtungsfaktor cᵢ kann beispielsweise die spezielle Position, d.h. die spezielle Modulaufnahme, berücksichtigt werden, in der ein Funktionsmodul 14, 16 eingesetzt ist. Selbstverständlich kann auf eine solche Wichtung auch verzichtet werden, d.h. der Wichtungsfaktor entspricht dann 1 bzw. ist in allen Summanden identisch.

Diese statische Kühlleistung Pₛₜ wird von der Kühlvorrichtung 34 an sämtliche geräteseitigen Thermo-Schnittstellenkomponenten 32a gleich verteilt. Die jeweils bedarfsgerechte Verteilung an die Funktionsmodule 14, 16 erfolgt über die unterschiedlichen Größen der modulseitigen Thermo-Schnittstellenkomponenten 32b.

Bei einer Weiterbildung dieser Kühlungssteuerung bildet die statische Kühlleistung Pₛₜ nur einen von mehreren Termen der Gesamtkühlleistung P: *P* = *P*₀ + *Pₛₜ* + *Pᵥ* mit *Pᵥ* = *Pᵥ*(*T*). Bei dieser Ausführungsform ist zusätzlich zur statischen Kühlleistung Pₛₜ noch ein geringer, geregelter Kühlleistungsbeitrag, die Korrekturkühlleistung Pᵥ vorgesehen, mit dem geringe Schwankungen der Temperatur T im Wägeraum 22 kompensiert werden können.

Natürlich stellen die in der speziellen Beschreibung diskutierten und in den Figuren gezeigten Ausführungsformen nur illustrative Ausführungsbeispiele der vorliegenden Erfindung dar. Dem Fachmann ist im Lichte der hiesigen Offenbarung ein breites Spektrum von Variationsmöglichkeiten an die Hand gegeben. Insbesondere ist es möglich, alternativ oder zusätzlich zur Wägeraumrückwand 28 eine oder mehrere der übrigen Wände der Wägeraumwandung in der beschriebenen Weise als Pfosten/Streben-Struktur mit als Modulaufnahmen ausgebildeten Ausnehmungen zu gestalten. In solchen Fällen, in denen die Modulaufnahmen nicht an einen, insbesondere aus eichrechtlichen Gründen zu versiegelnden Raum grenzen, wird eine spezielle Versiegelungswand wie bei der hier gezeigten Ausführungsform nicht erforderlich sein.

### Bezugszeichenliste

- 10: gravimetrisches Messsystem
- 12: Waage
- 14: Funktionsmodul
- 15: Blende
- 16: Funktionsmodul
- 18: Wägesystemraum
- 181: Wägesystem
- 20: Wägegutträger
- 22: Wägeraum
- 23: Wägeraumdeckel
- 24: Wägeraumboden
- 26: Wägeraumseitenwand
- 28: Wägeraumrückwand
- 281: Pfosten
- 282: Strebe
- 283: Ausnehmung/Modulaufnahme
- 284: Abschlusswand
- 30a/b: geräteseitige/modulseitige Identifikations-Schnittstellenkomponente
- 32a/b: geräteseitige/modulseitige Thermo-Schnittstellenkomponente
- 34: Kühlvorrichtung
- 36: Steuereinrichtung
- 361: Identifikationseinheit
- 362: Zentraleinheit
- 363: Speichereinheit
- 364: Kühlungssteuerungseinheit
- P: Gesamtkühlleistung
- P₀: Grundkühlleistung
- Pₛₜ: statische Kühlleistung
- Pᵥ: Korrekturkühlleistung
- cᵢ: Wichtungsfaktor
- Pₘᵢ: modulspezifische Wärmeleistung
- T: Temperatur (im Wägeraum)

## Patentansprüche

1. Gravimetrisches Messsystem (10), umfassend
- eine Waage (12) mit einem von einer Wägeraumwandung (23, 24, 26, 28) umgebenen Wägeraum (22), einem elektromechanischen Wägesystem (181) und einer elektronischen Steuereinrichtung (36) zur Steuerung des Systembetriebs gemäß in ihrem Speicher (363) hinterlegten Regeln sowie
- eine Mehrzahl von Funktionsmodulen (14, 16), die bedarfsweise in an der Wägeraumwandung (28) angeordnete Modulaufnahmen (283) einsetzbar sind,
wobei jede Modulaufnahme (283) eine geräteseitige Identifikationsschnittstellen-Komponente (30a) und jedes Funktionsmodul eine korrespondierende, modulseitige Identifikationsschnittstellen-Komponente (306) aufweist und wobei die Steuereinrichtung (36) eingerichtet ist, jedes in eine Modulaufnahme (283) eingesetzte Funktionsmodul (14, 16) durch Wechselwirkung zwischen der jeweiligen geräte- und modulseitigen Identifikationsschnittstellen-Komponenten (30a, b) zu identifizieren und auf Grundlage von in ihrem Speicher (363) hinterlegten Regeln eine von mehreren Betriebsvarianten auszuwählen,
**dadurch gekennzeichnet,**
**dass** die Waage (12) eine von der Steuereinrichtung (36) steuerbare Kühlvorrichtung (34) zur Kühlung des Wägeraums (22) aufweist, und die Steuereinrichtung (36) eingerichtet ist, die Kühlvorrichtung (34)
a) mit einer von der Art und Anzahl der identifizierten, bei Betrieb Wärme generierenden Funktionsmodule (14, 16) abhängigen, statischen Kühlleistung (Pₛₜ) anzusteuern
b) oder zur Konstanthaltung einer vorgegebenen Wägeraumtemperatur (T) mittels einer Regelung zu regeln, deren Regelparameter von der Art und Anzahl der identifizierten, bei Betrieb Wärme generierenden Funktionsmodule (14, 16) abhängig ist.

2. Gravimetrisches Messsystem (10) nach Anspruch 1,
**dadurch gekennzeichnet,**
**dass** im Fall a die Steuereinrichtung (36) weiter eingerichtet ist, die Kühlvorrichtung (34) zusätzlich mit einer von temporären Umgebungseinflüssen abhängigen, dynamischen Korrekturkühlleistung (Pᵥ) zu regeln.

## Claims

1. Gravimetric measuring system (10), comprising
- a scale (12) having a weighing chamber (22) surrounded by a weighing chamber wall (23, 24, 26, 28), an electromechanical weighing system (181), and an electronic control apparatus (36) for controlling the system operation according to rules stored in a memory (363) of the electronic control apparatus; as well as
- a plurality of functional modules (14, 16) which can be inserted, as required, into module receptacles (283) arranged on the weighing chamber wall (28),
wherein each module receptacle (283) has a device-side identification interface component (30a) and each functional module has a corresponding, module-side identification interface component (30b),
and wherein the control apparatus (36) is designed to identify each functional module (14, 16) inserted in a module receptacle (283) through interaction between the respective device-side and module-side identification interface components (30a, b) and to select one of a plurality of operating variants on the basis of rules stored in the memory (363),
**characterized in that**
the scale (12) comprises a cooling apparatus (34), controllable by the control apparatus (36), for cooling the weighing chamber (22), and the control apparatus (36) is designed to control the cooling apparatus (34)
a) with a static cooling capacity (Pₛₜ) which is dependent on the type and number of identified functional modules (14, 16) that generate heat during operation,
b) or to constantly maintain a specified weighing chamber temperature (T) by means of regulation, the regulation parameters of which are dependent on the type and number of identified functional modules (14, 16) that generate heat during operation.

2. Gravimetric measuring system (10) according to claim 1,
**characterized in that**
in case a) the control apparatus (36) is further designed to additionally control the cooling apparatus (34) with a dynamic correction cooling capacity (Pᵥ) which is dependent on temporary environmental influences.

## Revendications

1. Système de mesure (10) gravimétrique, qui comprend
- une balance (12) avec une chambre de pesée (22) entourée par une paroi de chambre de pesée (23, 24, 26, 28), un système de pesée (181) électromécanique et un équipement de commande (36) électronique pour commander le fonctionnement du système selon des règles consignées dans sa mémoire (363) ainsi que
- une pluralité de modules fonctionnels (14, 16) qui au besoin peuvent être utilisés dans des logements de module (283) agencés au niveau de la paroi de chambre de pesée (28),
dans lequel chaque logement de module (283) présente une composante d'interface d'identification (30a) du côté de l'appareil et chaque module fonctionnel présente une composante d'interface d'identification (30b) correspondante du côté du module
et dans lequel l'équipement de commande (36) est aménagé pour identifier chaque module fonctionnel (14, 16) utilisé dans un logement de module (283) par interaction entre les composantes d'interface d'identification (30a, b) respectives des côtés de l'appareil et du module et sélectionner l'une parmi plusieurs variantes de fonctionnement sur la base de règles consignées dans sa mémoire (363),
**caractérisé en ce que**
la balance (12) présente un dispositif de refroidissement (34) qui peut être commandé par l'équipement de commande (36) pour refroidir la chambre de pesée (22), et l'équipement de commande (36) est aménagé
a) pour piloter le dispositif de refroidissement (34) avec une capacité de refroidissement (Pₛₜ) statique, dépendante du type et du nombre des modules fonctionnels (14, 16) identifiés qui produisent de la chaleur en fonctionnement
b) ou pour régler le dispositif de refroidissement (34) de façon à maintenir constante une température de chambre de pesée (T) prédéfinie au moyen d'un réglage dont le paramètre de réglage statique est dépendant du type et du nombre de modules fonctionnels (14, 16) identifiés qui produisent de la chaleur en fonctionnement.

2. Système de mesure (10) gravimétrique selon la revendication 1,
**caractérisé en ce que**
dans le cas a, l'équipement de commande (36) est en outre aménagé pour régler le dispositif de refroidissement (34) en complément avec une capacité de refroidissement corrective (Pᵥ) dynamique dépendante de conditions environnementales temporaires.
